# EUROPEAN PATENT APPLICATION

(11) **EP 2 109 150 A1**
(43) Date of publication of application: **14.10.2009**
(21) Application number: 08703614.1
(22) Date of filing: 22.01.2008
(51) Int. Cl.: H01L 31/042

(54) **SOLAR CELL MODULE, WIRING MEMBER FOR SOLAR CELL, AND METHOD FOR MANUFACTURING SOLAR CELL MODULE**

(30) Priority: 31.01.2007 JP 2007022023
(71) Applicant: Sharp Kabushiki Kaisha, Osaka-shi, Osaka 545-8522 (JP)
(72) Inventor: INOUE, Tetsuyoshi, Osaka 545-8522 (JP)
(74) Representative: Müller - Hoffmann & Partner
(86) International application number: PCT/JP2008/050767
(87) International publication number: WO 2008/093563

(57) **Abstract**

A solar cell module of the present invention is provided with: a unit solar cell (2) in which a first electrode (21) and a second electrode (22) are formed in a non-light-receiving face; a solar cell wiring member (1) including a first conductor wire (11) connected to the first electrode (21), a second conductor wire (12) connected to the second electrode (22), and a wiring sheet (10) in which the first conductor wire (11) and the second conductor wire (12) are formed; and a sealing resin sheet (33) that is laminated on the unit solar cell (2) and the solar cell wiring member (1) and that resin-seals the unit solar cell (2).

## Description

### Technical Field

The present invention relates to a solar cell module in which conductor wires formed in a wiring sheet are connected to the electrodes of a unit solar cell to provide electricity, a solar cell wiring member applied to such a solar cell module, and a method of manufacturing such a solar cell module.

### Background Art

The technical development of solar photovoltaic power generation systems, which generate electric energy directly from the sun's rays through solar cells, has proceeded rapidly in recent years, and there are technical prospects for use as a practical power generation method. As a result, solar photovoltaic power generation systems are expected to become a major clean energy technology capable of protecting the global environment in the 21st century from environmental contamination due to the combustion of fossil fuels, in the future.

Various forms of solar cells are being developed and, among them, a solar cell that uses a group-IV semiconductor in a photoelectric conversion active layer is currently closest to practical use because low-cost production is possible, and a thin film solar cell in which a thin film semiconductor is formed on an insulating substrate is the one that consumes the least amount of semiconductor material.

Ordinarily, a thin film solar cell has two types of structures: a structure in which on a transparent conductive film, such as SnO₂ (stannic oxide) or ITO (indium tin oxide), formed on a light-transmitting insulating substrate such as glass, a p layer, an i layer and an n layer of amorphous semiconductor are laminated in this order, forming a photoelectric conversion active layer, and a metal thin film electrode is laminated thereon; and a structure in which a p layer, an i layer and an n layer of amorphous semiconductor are laminated on a metal substrate electrode in this order, forming a photoelectric conversion active layer, and a transparent conductive film is laminated thereon.

Of these types, the former method of sequentially laminating a p layer, an i layer and an n layer is widely used and currently the dominant method because the light-transmitting insulating substrate can also serve as a solar cell surface cover glass and the development of a plasma-resistant transparent conductive film, such as SnO₂, has made it possible to laminate a photoelectric conversion active layer of amorphous semiconductor onto the plasma-resistant transparent conductive film by a plasma CVD method. Amorphous semiconductor layers used for such solar cells are formed by a plasma CVD method through the glow discharge decomposition of a raw material gas or by photochemical vapor deposition (photo CVD method), and these methods are advantageous in that it is possible to form large-area thin films.

Ordinarily, in order to achieve a large area, a method is used in which components are integrated and connected in series using a laser. In this structure, a transparent conductive film is formed on a light-transmitting insulating substrate, such as a glass substrate, in the form of strips, and an amorphous semiconductor layer and a back surface electrode are sequentially laminated thereon. Then, a pattern for the two electrodes and the amorphous semiconductor layer is formed so as to achieve a structure in which the transparent conductive film of a unit solar cell composed of a transparent conductive film, an amorphous semiconductor layer and a back surface electrode contacts the back surface electrode of an adjacent unit solar cell. A flat p-i-n layer type thin film solar cell as configured above is conventionally known (see for example, Patent Document 1).

According to conventional technology, as wiring for providing electricity from the electrodes of a solar cell (unit solar cell) that are formed on a large area substrate, a plurality of wires (electric wires) composed of copper wires coated with an insulating coating are used, and the wires are connected to the electrodes by soldering.
[Patent Document 1] JP H8-83922A

### Disclosure of Invention

### Problems to be Solved by the Invention

As described above, according to conventional technology, separate wires are used as the electric wires for providing electricity from a unit solar cell, and the wires are separately positioned to the electrodes of the unit solar cell and then connected by soldering. Accordingly, conventional technology has problems such as poor positional accuracy, and poor productivity due to a large number of process steps.

The present invention has been conceived under such circumstances, and it is an object of the present invention to provide a highly reliable solar cell module, with which the positional accuracy when connecting a solar cell wiring member as an electric wire for providing electricity to the outside to the electrodes of a unit solar cell is improved, enhancing productivity, by configuring the solar cell module using a solar cell wiring member including, as electric wires for a unit solar cell including a first electrode and a second electrode on a non-light-receiving face, a first conductor wire connected to the first electrode, a second conductor wire connected to the second electrode, and a wiring sheet in which the first conductor wire and the second conductor wire are formed.

It is another object of the present invention to provide a solar cell wiring member that is provided with: a first conductor wire including a first electrode connecting portion connected to a first electrode and a first lead-out portion connected to the outside via a first through portion formed through a wiring sheet; a second conductor wire including a second electrode connecting portion connected to a second electrode and a second lead-out portion connected to the outside via a second through portion formed through the wiring sheet; and the wiring sheet in which the first conductor wire and the second conductor wire are formed, with which it is possible to define the positioning between the first electrode and the first electrode connecting portion as well as the positioning between the second electrode and the second electrode connecting portion with ease and high accuracy and connect them with good productivity, and to manufacture a highly reliable solar cell module with superior productivity.

It is another object of the present invention to provide a method of manufacturing a solar cell module that involves: a preparation step of preparing a unit solar cell including a first electrode and a second electrode on a non-light-receiving face; a wiring member connecting step of positioning and disposing a solar cell wiring member on the first electrode and the second electrode and connecting a first electrode connecting portion of a first conductor wire to the first electrode and a second electrode connecting portion of a second conductor wire to the second electrode with a conductive adhesive; a sealing resin sheet disposing step of disposing a sealing resin sheet so as to overlap the non-light-receiving face and the solar cell wiring member; and a resin sealing step of heating and pressing the sealing resin sheet to resin-seal the unit solar cell, with which it is possible to position the first conductor wire to the first electrode and position the second conductor wire to the second electrode with ease and high accuracy, and productivity is improved by using a conductive adhesive to connect the first conductor wire to the first electrode and the second conductor wire to the second electrode.

It is another object of the present invention to provide a highly reliable solar cell module, with which the positional accuracy when connecting a solar cell wiring member as an electric wire for providing electricity to the outside to the electrodes of a unit solar cell is improved, enhancing productivity, by configuring the solar cell module using a solar cell wiring member including, as electric wires for a unit solar cell including a first electrode and a second electrode on a non-light-receiving face, a first conductor wire connected to the first electrode, a second conductor wire connected to the second electrode, and an insulating sheet in which the first conductor wire and the second conductor wire are fixed.

It is another object of the present invention to provide a solar cell wiring member that is provided with a first conductor wire connected to a first electrode, a second conductor wire connected to a second electrode, and an insulating sheet in which the first conductor wire and the second conductor wire are fixed, with which it is possible to define the positioning between the first electrode and the first conductor wire as well as the positioning between the second electrode and the second conductor wire with ease and high accuracy and connect them with good productivity, and to manufacture a highly reliable solar cell module with superior productivity.

### Means for solving the Problems

A solar cell module of the present invention is a solar cell module including: a unit solar cell in which a first electrode of a first polarity and a second electrode of a second polarity are formed in a non-light-receiving face; a solar cell wiring member that is disposed facing the non-light-receiving face and that provides electricity to the outside; and a sealing resin sheet that is laminated on the unit solar cell and the solar cell wiring member and that resin-seals the unit solar cell, wherein the solar cell wiring member comprises a first conductor wire connected to the first electrode, a second conductor wire connected to the second electrode, and a wiring sheet in which the first conductor wire and the second conductor wire are formed, the first conductor wire includes a first electrode connecting portion connected to the first electrode and a first lead-out portion that is connected to the outside via a first through portion formed through the wiring sheet, the second conductor wire includes a second electrode connecting portion connected to the second electrode and a second lead-out portion that is connected to the outside via a second through portion formed through the wiring sheet, and an insulating sheet that covers the first conductor wire and the second conductor wire to insulate the first conductor wire and the second conductor wire is disposed between the non-light-receiving face and the wiring sheet.

With this configuration, it becomes possible to integrally fix the positions of the first electrode connecting portion, the first lead-out portion, the second electrode connecting portion and the second lead-out portion by the wiring sheet and, as such, the positioning between the first electrode and the first electrode connecting portion as well as the positioning between the second electrode and the second electrode connecting portion can be defined with ease and high accuracy so that they can be connected with good productivity. Accordingly, it is possible to obtain a highly reliable solar cell module with superior productivity. In addition, the positioning of the first and second lead-out portions to the outside can be defined with ease and high accuracy. That is, it is possible to provide wiring that can be easily incorporated into the solar cell wiring member and has high positional accuracy.

Also, in the solar cell module of the present invention, the first electrode and the first electrode connecting portion as well as the second electrode and the second electrode connecting portion are connected with a conductive adhesive.

With this configuration, the conductive adhesive used to connect the first electrode connecting portion to the first electrode and the second electrode connecting portion to the second electrode can be cured concurrently when the sealing resin sheet is heated and pressed to firmly attach it to the unit solar cell, so it becomes possible to easily perform manufacturing at a low temperature. Accordingly, it is possible to obtain a highly productive solar cell module in a shortened connection time.

Also, in the solar cell module of the present invention, the insulating sheet is formed so as to cause the first electrode connecting portion to correspond to the first electrode and the second electrode connecting portion to correspond to the second electrode, and is deposited on the wiring sheet.

With this configuration, it becomes possible to insulate the first conductor wire and the second conductor wire in advance. Accordingly, when disposing the wiring sheet facing the unit solar cell, the need for an extra task of inserting an insulating sheet that is necessary between the first and second conductor wires and the unit solar cell is eliminated, simplifying the manufacturing process and, as a result, improving productivity.

Also, in the solar cell module of the present invention, the unit solar cell is a thin film solar cell.

With this configuration, it becomes possible to obtain a highly productive and inexpensive solar cell module.

A solar cell wiring member according to the present invention is a solar cell wiring member including: a first conductor wire that is connected to a first electrode of a first polarity formed in a non-light-receiving face of a unit solar cell; a second conductor wire that is connected to a second electrode of a second polarity formed in the non-light-receiving face of the unit solar cell; and a wiring sheet in which the first conductor wire and the second conductor wire are formed, the solar cell wiring member being disposed facing the non-light-receiving face of the unit solar cell and providing electricity to the outside, wherein the first conductor wire includes a first electrode connecting portion that is connected to the first electrode and a first lead-out portion that is connected to the outside via a first through portion formed through the wiring sheet, and the second conductor wire includes a second electrode connecting portion that is connected to the second electrode and a second lead-out portion connected to the outside via a second through portion formed through the wiring sheet.

With this configuration, it becomes possible to integrally fix the positions of the first electrode connecting portion, the first lead-out portion, the second electrode connecting portion and the second lead-out portion by using the wiring sheet and, as such, the positioning of the first electrode connecting portion to the first electrode as well as the positioning of the second electrode connecting portion to the second electrode can be defined with ease and high accuracy so that they can be connected with good productivity. Accordingly, it is possible to obtain a highly reliable solar cell module with superior productivity. In addition, the positioning of the first and second lead-out portions to the outside can be defined with ease and high accuracy, so the productivity of the solar cell module can be improved.

Also, in the solar cell wiring member of the present invention, an insulating sheet that is formed so as to cause the first electrode connecting portion to correspond to the first electrode and the second electrode connecting portion to correspond to the second electrode and that covers the first conductor wire and the second conductor wire to insulate the first conductor wire and the second conductor wire is deposited on the wiring sheet.

With this configuration, it becomes possible to insulate the first conductor wire and the second conductor wire in advance. Accordingly, when disposing the wiring sheet facing the unit solar cell, the need for an extra step of inserting an insulating sheet that is necessary between the first and second conductor wires and the unit solar cell is eliminated, simplifying the manufacturing process and, as a result, improving productivity.

Also, in the solar cell wiring member of the present invention, the first conductor wire and the second conductor wire are formed of a thin plate-like metal conductor.

With this configuration, it becomes possible to form the first conductor wire and the second conductor wire with ease, so a solar cell wiring member can be obtained with good productivity.

Also, in the solar cell wiring member of the present invention, the first conductor wire and the second conductor wire are formed of an aggregate of conductor particles.

With this configuration, it becomes possible to form the first conductor wire and the second conductor wire with ease, so a solar cell wiring member can be obtained with good productivity.

A method of manufacturing a solar cell module according to the present invention is a method of manufacturing a solar cell module including: a unit solar cell in which a first electrode of a first polarity and a second electrode of a second polarity are formed in a non-light-receiving face; a solar cell wiring member including a first conductor wire connected to the first electrode, a second conductor wire connected to the second electrode, and a wiring sheet in which the first conductor wire and the second conductor wire are formed, the solar cell wiring member that is disposed facing the non-light-receiving face and that provides electricity to the outside; and a sealing resin sheet that is laminated on the unit solar cell and the solar cell wiring member and that resin-seals the unit solar cell, the method including: a cell preparation step of preparing the unit solar cell; a wiring member connecting step of positioning and disposing the solar cell wiring member on the first electrode and the second electrode and connecting a first electrode connecting portion of the first conductor wire to the first electrode and a second electrode connecting portion of the second conductor wire to the second electrode with a conductive adhesive; a sealing resin sheet disposing step of disposing the sealing resin sheet so as to overlap the non-light-receiving face and the solar cell wiring member; and a resin sealing step of heating and pressing the sealing resin sheet to resin-seal the unit solar cell.

With this configuration, it becomes possible to position the first conductor wire to the first electrode and position the second conductor wire to the second electrode with ease and high accuracy. In addition, because a conductive adhesive is used to connect them, the productivity of the solar cell module can be improved.

Also, in the method of manufacturing a solar cell module of the present invention, the conductive adhesive has a melting point lower than the melting point of the sealing resin sheet.

With this configuration, it becomes possible to cure the conductive adhesive concurrently with the resin-sealing of the sealing resin sheet in the resin sealing step. Accordingly, a highly productive manufacturing method of a solar cell module with simplified process steps can be obtained.

Also, in the method of manufacturing a solar cell module of the present invention, an insulating sheet that covers the first conductor wire and the second conductor wire to insulate the first conductor wire and the second conductor wire is deposited on the wiring sheet in advance.

With this configuration, it becomes possible to simplify the process steps and position the solar cell wiring member with ease.

A solar cell module according to the present invention is a solar cell module including: a unit solar cell in which a first electrode of a first polarity and a second electrode of a second polarity are formed in a non-light-receiving face; a solar cell wiring member that is disposed facing the non-light-receiving face and that provides electricity to the outside; and a sealing resin sheet that is laminated on the unit solar cell and the solar cell wiring member and that resin-seals the unit solar cell, wherein the solar cell wiring member comprises a first conductor wire connected to the first electrode, a second conductor wire connected to the second electrode, and an insulating sheet in which the first conductor wire and the second conductor wire are fixed; and is configured to provide electricity to the outside by the first conductor wire and the second conductor wire.

With this configuration, the positions of the first conductor wire and the second conductor wire are integrally fixed by the insulating sheet and, as such, the positioning of the first conductor wire to the first electrode as well as the positioning of the second conductor wire to the second electrode can be defined with ease and high accuracy so that they can be connected with good productivity. Accordingly, a highly reliable solar cell module can be obtained with superior productivity. That is, it is possible to provide wiring that can be easily incorporated into the solar cell wiring member and has high positional accuracy.

In addition, because the first conductor wire and the second conductor wire are fixed to the insulating sheet, the first conductor wire and the second conductor wire can be insulated in advance, so the need for an extra task of inserting an insulating sheet between the first and second conductor wires and the unit solar cell can be eliminated, and the manufacturing process can be simplified, improving productivity.

A solar cell wiring member according to the present invention is a solar cell wiring member including: a first conductor wire that is connected to a first electrode of a first polarity formed in a non-light-receiving face of a unit solar cell; a second conductor wire that is connected to a second electrode of a second polarity formed in the non-light-receiving face of the unit solar cell; and an insulating sheet in which the first conductor wire and the second conductor wire are fixed, the solar cell wiring member being disposed facing the non-light-receiving face of the unit solar cell and being configured to provide electricity to the outside by the first conductor wire and the second conductor wire.

With this configuration, the positions of the first conductor wire and the second conductor wire can be fixed by the insulating sheet, so it becomes possible to define the positioning of the first conductor wire to the first electrode and the positioning of the second conductor wire to the second electrode with ease and high accuracy and connect them with good productivity. Accordingly, it is possible to manufacture a highly reliable solar cell module with superior productivity. Furthermore, the first and second conductor wires can be positioned to the outside with ease and high accuracy, so the productivity of the solar cell module can be improved.

In addition, because the first conductor wire and the second conductor wire are fixed to the insulating sheet, the first conductor wire and the second conductor wire can be insulated in advance, so the need for an extra task of inserting an insulating sheet between the first and second conductor wires and the unit solar cell can be eliminated, and the manufacturing process can be simplified, improving productivity.

A method of manufacturing a solar cell module according to the present invention is a method of manufacturing a solar cell module including: a unit solar cell in which a first electrode of a first polarity and a second electrode of a second polarity are formed in a non-light-receiving face; a solar cell wiring member including a first conductor wire connected to the first electrode, a second conductor wire connected to the second electrode, and an insulating sheet in which the first conductor wire and the second conductor wire are fixed, the solar cell wiring member being disposed facing the non-light-receiving face and providing electricity to the outside; and a sealing resin sheet being laminated on the unit solar cell and the solar cell wiring member and resin-sealing the unit solar cell, the method including: a cell preparation step of preparing the unit solar cell; a wiring member connecting step of positioning and disposing the solar cell wiring member on the first electrode and the second electrode and connecting a first electrode connecting portion of the first conductor wire to the first electrode and a second electrode connecting portion of the second conductor wire to the second electrode; a sealing resin sheet disposing step of disposing the sealing resin sheet so as to overlap the non-light-receiving face and the solar cell wiring member; and a resin sealing step of heating and pressing the sealing resin sheet to resin-seal the unit solar cell.

With this configuration, it becomes possible to position the first conductor wire to the first electrode and position the second conductor wire to the second electrode with ease and high accuracy. In addition, by using a conductive adhesive to connect the first electrode connecting portion to the first electrode and the second electrode connecting portion to the second electrode, the productivity of the solar cell module can be improved.

Furthermore, it becomes possible to simplify the process steps and position the solar cell wiring member with ease.

### Effects of the Invention

In accordance with the solar cell module of the present invention, the solar cell wiring member that is disposed facing a non-light-receiving face of a unit solar cell in which a first electrode and a second electrode are formed and that provides electricity to the outside is provided with: a first conductor wire including a first electrode connecting portion connected to the first electrode and a first lead-out portion connected to the outside via a first through portion formed through a wiring sheet; a second conductor wire including a second electrode connecting portion connected to the second electrode and a second lead-out portion connected to the outside via a second through portion formed through the wiring sheet; and the wiring sheet in which the first conductor wire and the second conductor wire are formed, as a result of which the following effects can be achieved: the positions of the first electrode connecting portion, the first lead-out portion, the second electrode connecting portion and the second lead-out portion can be fixed by the wiring sheet, which makes it possible to define the positioning between the first electrode and the first electrode connecting portion and the positioning between the second electrode and the second electrode connecting portion with ease and high accuracy and connect them with good productivity, and also makes it possible to provide a highly reliable solar cell module with superior productivity.

In accordance with the solar cell wiring member of the present invention, a first conductor wire including a first electrode connecting portion connected to a first electrode and a first lead-out portion connected to the outside via a first through portion formed through a wiring sheet, a second conductor wire including a second electrode connecting portion connected to a second electrode and a second lead-out portion connected to the outside via a second through portion formed through the wiring sheet, and the wiring sheet in which the first conductor wire and the second conductor wire are formed are provided, as a result of which the following effects can be achieved: the positions of the first electrode connecting portion, the first lead-out portion, the second electrode connecting portion and the second lead-out portion can be fixed by the wiring sheet, which makes it possible to define the positioning of the first electrode connecting portion to the first electrode as well as the positioning of the second electrode connecting portion to the second electrode with ease and high accuracy and connect them with good productivity. That is, a highly reliable solar cell module can be manufactured with superior productivity.

In accordance with the method of manufacturing a solar cell module of the present invention, a cell preparation step of preparing a unit solar cell in which a first electrode and a second electrode are formed in a non-light-receiving face; a wiring member connecting step of positioning and disposing a solar cell wiring member on the first electrode and the second electrode and connecting a first electrode connecting portion of a first conductor wire to the first electrode and a second electrode connecting portion of a second conductor wire to the second electrode with a conductive adhesive; a sealing resin sheet disposing step of disposing a sealing resin sheet so as to overlap the non-light-receiving face and the solar cell wiring member; and a resin sealing step of heating and pressing the sealing resin sheet to resin-seal the unit solar cell are involved; as a result of which, the following effects can be achieved: the positioning of the first conductor wire to the first electrode as well as the positioning of the second conductor wire to the second electrode can be performed with ease and high accuracy. Also, a conductive adhesive is used to connect them, so the effect of improving the productivity of the solar cell module can be obtained.

In accordance with the solar cell module of the present invention, the solar cell wiring member that is disposed facing a non-light-receiving face of a unit solar cell in which a first electrode and a second electrode are formed and that provides electricity to the outside is provided with: a first conductor wire connected to the first electrode, a second conductor wire connected to the second electrode, and an insulating sheet in which the first conductor wire and the second conductor wire are fixed, as a result of which, the positions of the first conductor wire and the second conductor wire can be fixed by the insulating sheet, so the following effects can be achieved: the positioning between the first electrode and the first conductor wire and the positioning between the second electrode and the second conductor wire can be performed with ease and high accuracy so that they can be connected with good productivity, and a highly reliable solar cell module can be provided with superior productivity.

In accordance with the solar cell wiring member of the present invention, a first conductor wire connected to a first electrode of a first polarity formed in a non-light-receiving face of a unit solar cell, a second conductor wire connected to a second electrode of a second polarity formed in the non-light-receiving face of the unit solar cell, and an insulating sheet in which the first conductor wire and the second conductor wire are fixed are provided, as a result of which the positions of the first conductor wire and the second conductor wire are fixed by the insulating sheet, so the following effects can be achieved: the positioning of the first conductor wire to the first electrode as well as the positioning of the second conductor wire to the second electrode can be performed with ease and high accuracy so that they can be connected with good productivity. That is, a highly reliable solar cell module can be manufactured with superior productivity.

### Brief Description of Drawings

[FIG. 1] FIG. 1 is an exploded perspective view showing an overall configuration of a solar cell wiring member according to Embodiment 1 of the present invention.
[FIG. 2] FIG. 2 is a perspective view showing the outer appearance of the solar cell wiring member shown in FIG. 1 in its completed state.
[FIG. 3] FIG. 3 is an exploded perspective view showing an overall configuration of a solar cell module used to illustrate a solar cell module and a method of manufacturing a solar cell module according to Embodiment 2 of the present invention.
[FIG. 4] FIG. 4 is an exploded perspective view showing the relationship between a unit solar cell and a solar cell wiring member that are applied to a solar cell module according to Embodiment 3 of the present invention.
[FIG. 5] FIG. 5 is a perspective view showing a state in which the unit solar cell and the solar cell wiring member shown in FIG. 4 are laminated and connected.
[FIG. 6] FIG. 6 is a perspective view showing the outer appearance of a solar cell wiring member according to Embodiment 4 of the present invention in its completed state.
[FIG. 7] FIG. 7 is an exploded perspective view showing an overall configuration of a solar cell module used to illustrate a solar cell module and a method of manufacturing a solar cell module according to Embodiment 4 of the present invention.

### Description of Reference Numerals

- 1, 1a: Solar Cell Wiring Member
- 2: Unit Solar Cell
- 3: Solar Cell Module
- 10: Wiring Sheet
- 10h, 13h: Fixing Hole (Anchor Hole)
- 11: First Conductor Wire
- 11c: First Electrode Connecting Portion
- 11h: First Through Portion
- 11t: First Lead-Out Portion
- 12: Second Conductor Wire
- 12c: Second Electrode Connecting Portion
- 12h: Second Through Portion
- 12t: Second Lead-Out Portion
- 13: Insulating Sheet
- 13k: Cut-Out Portion
- 14: Auxiliary Fixing Tape
- 20: Photoelectric Conversion Portion
- 21: First Electrode
- 22: Second Electrode
- 31: Light-Transmitting Protection Plate
- 32: Sealing Resin Sheet
- 33: Sealing Resin Sheet
- 33h: Terminal Hole
- 34: Exterior Sheet
- 34h: Terminal Hole
- 35: Terminal Box
- 36: Output Lead Wire
- 37: Frame Member

### Best Mode for Carrying Out the Invention

Hereinafter, embodiments of the present invention will be described with reference to the accompanying drawings.

### Embodiment 1

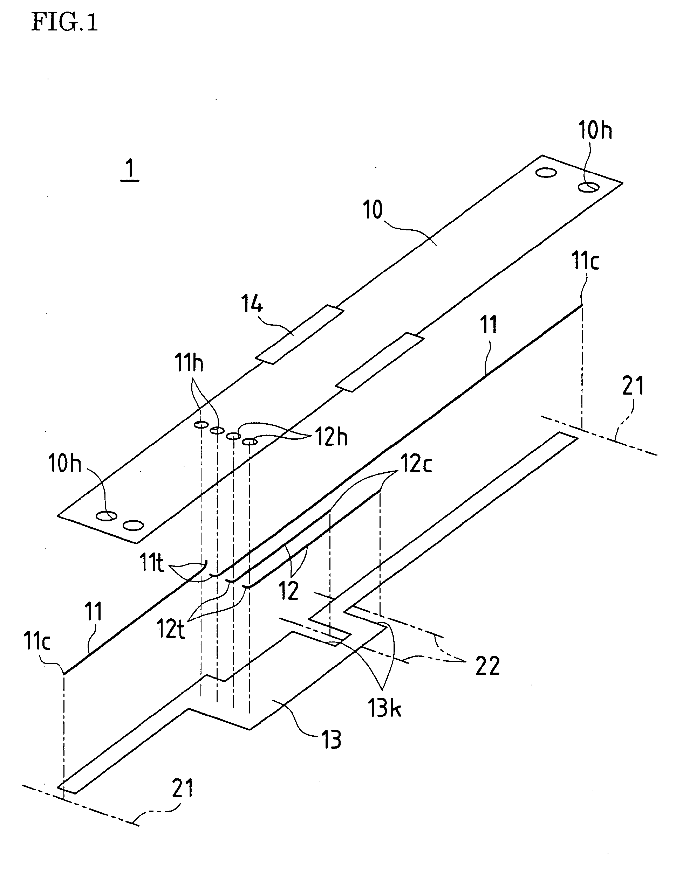

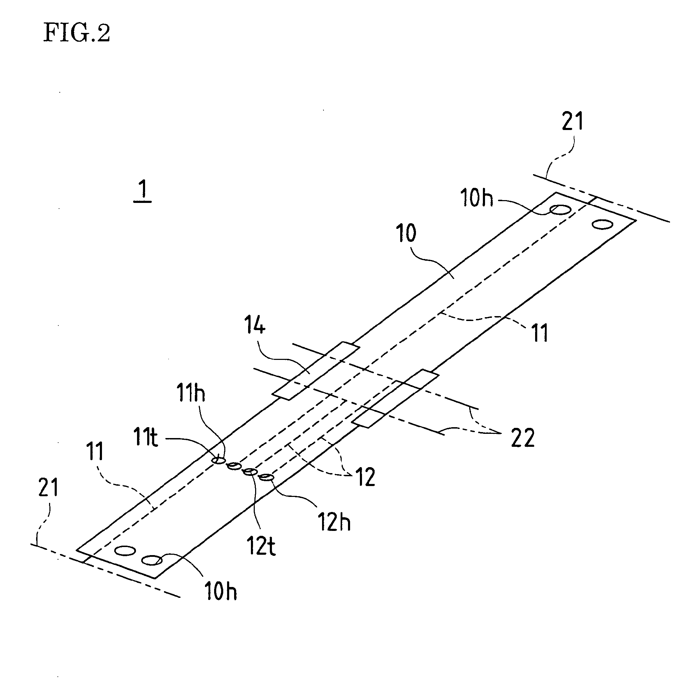

A solar cell wiring member according to Embodiment 1 of the present invention will be described with reference to FIGS. 1 and 2.

FIG. 1 is an exploded perspective view showing an overall configuration of a solar cell wiring member according to Embodiment 1 of the present invention. FIG. 2 is a perspective view showing the outer appearance of the solar cell wiring member shown in FIG. 1 in its completed state.

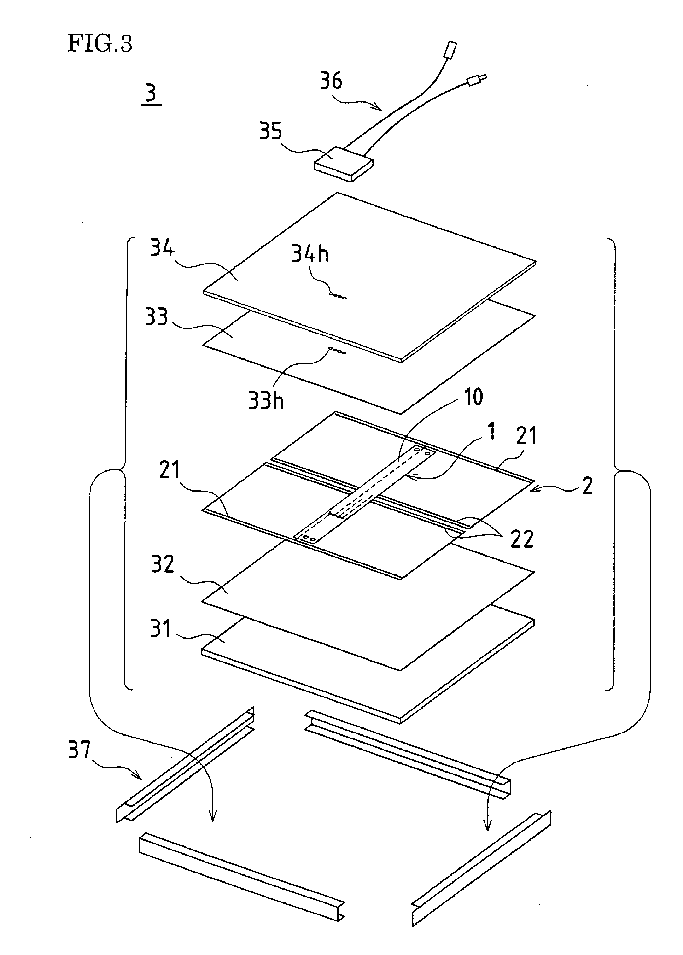

A solar cell wiring member 1 according to the present embodiment is provided with a first conductor wire 11 that is connected to a first electrode 21 of a first polarity (e.g., p-electrode) formed on a non-light-receiving face of a unit solar cell 2 (see FIG. 3), a second conductor wire 12 that is connected to a second electrode 22 of a second polarity (e.g., n-electrode) formed on the non-light-receiving face of the unit solar cell 2, and a wiring sheet 10 in which the first conductor wire 11 and the second conductor wire 12 are formed; and is configured such that the first conductor wire 11 and the second conductor wire 12 are disposed facing the non-light-receiving face of the unit solar cell 2 to provide electricity to the outside. Herein, a plurality of first conductor wires 11 and a plurality of second conductor wires 12 are arranged according to the number of unit solar cells 2.

The first conductor wire 11 includes a first electrode connecting portion 11c that is connected to the first electrode 21 and a first lead-out portion 11t that is connected to the outside via a first through portion 11h formed through the wiring sheet 10. Likewise, the second conductor wire 12 includes a second electrode connecting portion 12c that is connected to the second electrode 22 and a second lead-out portion 12t that is connected to the outside via a second through portion 12h formed through the wiring sheet 10. That is, the first conductor wire 11 and the second conductor wire 12 are formed so as to be disposed on one face of the wiring sheet 10 facing the non-light-receiving face of the unit solar cell 2.

In the first lead-out portion 11t and the second lead-out portion 12t, lead-out terminals may be configured using appropriate lead wires. It is desirable that the first through portion 11h and the second through portion 12h are aligned as appropriate. By aligning them, the connection of the first lead-out portions 11t and the second lead-out portions 12t to the outside can be achieved collectively and efficiently.

The connection between the first electrode connecting portion 11c and the first electrode 21 and the connection between the second electrode connecting portion 12c and the second electrode 22 are formed by disposing them so as to correspond to each other and bonding them with a conductive adhesive. By using a conductive adhesive, unlike conventional soldering, the processing time can be reduced. It also becomes possible to cure the conductive adhesive in a resin sealing step (see FIG. 3) of resin-sealing the unit solar cell 2 by heating and pressing a sealing resin sheet 33, so the productivity of solar cell module 3 (see FIG. 3) can be improved. Accordingly, as the conductive adhesive, an adhesive_having a melting point lower than the temperature applied in the manufacturing process of the solar cell module 3 is used, and the conductive adhesive is configured to achieve reliable bonding by a heat history of, for example, approximately 100°C that is applied in the manufacturing process of the solar cell module 3.

Also, the first through portion 11h and the second through portion 12h can be configured of a through hole, a cutout or the like. With the first through portion 11h and the second through portion 12h, the first lead-out portion 11t and the second lead-out portion 12t can be connected to the outside.

The wiring sheet 10 is a single sheet member in which the first conductor wire 11 and the second conductor wire 12 are integrally formed. Because the first conductor wire 11 and the second conductor wire 12 are integrated as a wiring member, the positioning of the first conductor wire 11 to the first electrode 21 and the positioning of the second conductor wire 12 to the second electrode 22 can be performed with ease and high accuracy, and the number of manufacturing steps can be reduced.

The wiring sheet 10 can be formed as a multilayer structure in which a plurality of layers are laminated. It is also possible to reduce the wiring pitch of the first conductor wire 11 and the second conductor wire 12, so the necessary area for the solar cell wiring member 1 can be reduced. Accordingly, highly dense wiring and a more complicated wiring pattern can be formed. Also, a free wiring pattern can be formed, so the cost of components can be reduced, improving reliability.

It is desirable to use, as the wiring sheet 10, a material having a glass transition point temperature and a melting point higher than those of other resin materials that constitute the solar cell module 3 in order to prevent the material from degradation due to thermal stress in the manufacturing process. For example, a PET (polyethylene terephthalate) film or the like can be used.

According to the present embodiment, because the positions of the first electrode connecting portion 11c, the first lead-out portion 11t, the second electrode connecting portion 12c and the second lead-out portion 12t can be fixed by the wiring sheet 10, it becomes possible to define the positioning between the first electrode 21 and the first electrode connecting portion 11c and the positioning between the second electrode 22 and the second electrode connecting portion 12c with ease and high accuracy so that they can be connected with good productivity. Accordingly, a highly reliable solar cell module 3 can be manufactured with superior productivity (see FIG. 3).

It also becomes possible to position the first lead-out portion 11t to the outside and the second lead-out portion 12t to the outside with ease and high accuracy, so the productivity of the solar cell module 3 can be improved.

It is desirable that the first conductor wire 11 and the second conductor wire 12 are formed of, for example, a metal conductor in the form of a thin plate. With this configuration, the first conductor wire 11 and the second conductor wire 12 can be formed easily, so a solar cell wiring member 1 can be obtained with good productivity. The first conductor wire 11 and the second conductor wire 12 can be formed by, for example, laminating a thin copper plate on the wiring sheet 10 with an adhesive, followed by pattern etching (printing technique). That is, an ordinary printed circuit board technique can be applied to form them.

The first conductor wire 11 and the second conductor wire 12 can also be formed of, for example, an aggregate of conductor particles instead of a thin plate-like metal conductor. With this configuration, the first conductor wire 11 and the second conductor wire 12 can be formed easily, so a solar cell wiring member 1 can be obtained with good productivity. The first conductor wire 11 and the second conductor wire 12 can be formed by, for example, forming an aggregate of conductor particles (various techniques can be used to form such an aggregate such as applying a conductive paste or forming a vapor deposition film using a metal vapor deposition source), followed by pattern etching (printing technique). In the case where the first conductor wire 11 and the Second conductor wire 12 are formed of an aggregate of conductor particles, it is preferable to reinforce the first electrode connecting portion 11c, the first lead-out portion 11t, the second electrode connecting portion 12c and the second lead-out portion 12t with a thin plate-like metal conductor as appropriate.

When disposing the solar cell wiring member 1 on the non-light-receiving face of the unit solar cell 2 with the first conductor wire 11 and the second conductor wire 12 facing the non-light-receiving face, an insulating sheet 13 is interposed (disposed) therebetween in order to secure insulation between the unit solar cell 2 and the first and second conductor wires 11 and 12.

It is desirable that the insulating sheet 13 is deposited on the wiring sheet 10 in advance. That is, an insulating sheet that is formed so as to cause the first electrode connecting portion 11c to correspond to the first electrode 21 and the second electrode connecting portion 12c to correspond to the second electrode 22, and that covers the first conductor wire 11 and the second conductor wire 12 so as to insulate them is deposited (bonded, laminated) on the wiring sheet 10. The insulating sheet 13 can be formed from, for example, a cut-out portion 13k formed in the position corresponding to the second electrode connecting portion 12c.

With this configuration, the first conductor wire 11 and the second conductor wire 12 are insulated in advance. Accordingly, when disposing the wiring sheet facing the unit solar cell 2, the need for an extra step of inserting an insulating sheet 13 that is necessary between the first and second conductor wires 11 and 12 and the unit solar cell 2 can be eliminated, so the manufacturing process can be simplified, improving productivity.

As is the case with the wiring sheet 10, it is desirable to use, as the insulating sheet 13, a material having a glass transition point temperature and a melting point higher than those of other resin materials that constitute the solar cell module 3 in order to prevent the material from degradation due to thermal stress in the manufacturing process. It is possible to use, for example, a PET film or the like, as is the case with the wiring sheet 10.

The positioning and fixation of the wiring sheet 10 onto the solar cell module 3 (the positioning and fixation thereof to the unit solar cell 2) can be performed by providing fixing holes (anchor holes) 10h in the wiring sheet 10, and filling the fixing holes 10h with a sealing resin supplied from the sealing resin sheet 33 in a resin sealing step of resin-sealing the unit solar cell 2 by heating and pressing the sealing resin sheet 33.

In order to fix the wiring sheet 10 to the unit solar cell 2, auxiliary fixing tape 14 can also be used to tape the wiring sheet 10 to the unit solar cell 2. With this configuration, the position at which the first electrode connecting portion 11c and the first electrode 21 are connected as well as the position at which the second electrode connecting portion 12c and the second electrode 22 are connected can be fixed reliably, so they can be connected with high positional accuracy.

### Embodiment 2

FIG. 3 is an exploded perspective view showing an overall configuration of a solar cell module used to illustrate a solar cell module and a method of manufacturing a solar cell module according to Embodiment 2 of the present invention.

Because the solar cell wiring member 1 was described in detail in Embodiment 1, (FIG. 1, FIG. 2), some parts of the solar cell wiring member 1 are omitted in FIG. 3. The relationship between the solar cell wiring member 1 and the unit solar cell 2 will be described in detail in Embodiment 3.

A solar cell module 3 of the present embodiment is provided with: a unit solar cell 2 in which a first electrode 21 of a first polarity and a second electrode 22 of a second polarity are formed on a non-light-receiving face; a solar cell wiring member 1 that is disposed facing the non-light-receiving face and that provides electricity to the outside; and a sealing resin sheet 33 that is laminated on the unit solar cell 2 and the solar cell wiring member 1 and that seals the unit solar cell 2 with resin.

The solar cell wiring member 1 is the same as described in Embodiment 1. That is, the solar cell wiring member 1 is provided with a first conductor wire 11 connected to a first electrode 21, a second conductor wire 12 connected to a second electrode 22, and a wiring sheet 10 in which the first conductor wire 11 and the second conductor wire 12 are formed, the first conductor wire 11 including a first electrode connecting portion 11c connected to a first electrode 21 and a first lead-out portion 11t connected to the outside via a first through portion 11h formed through the wiring sheet 10, and the second conductor wire 12 including a second electrode connecting portion 12c connected to the second electrode 22 and a second lead-out portion 12t connected to the outside via a second through portion 12h formed through the wiring sheet 10. An insulating sheet 13 that covers the first conductor wire 11 and the second conductor wire 12 to insulate them is disposed between the non-light-receiving face and the wiring sheet 10.

Accordingly, in the solar cell module 3 of the present embodiment, the positions of the first electrode connecting portion 11c, the first lead-out portion 11t, the second electrode connecting portion 12c and the second lead-out portion 12t can be fixed using the wiring sheet 10, so it becomes possible to define the positioning between the first electrode 21 and the first electrode connecting portion 11c, and the positioning between the second electrode 22 and the second electrode connecting portion 12c with ease and high accuracy so that they can be connected with good productivity. Accordingly, it is possible to obtain a highly reliable solar cell module 3 with superior productivity. It also becomes possible to define the positioning between the first and second lead-out portions 11t and 12t and the outside with ease and high accuracy.

The first electrode 21 and the first electrode connecting portion 11c, as well as the second electrode 22 and the second electrode connecting portion 12c are connected with a conductive adhesive. Because the conductive adhesive can be cured concurrently when the sealing resin sheet 33 is heated and pressed to firmly attach it to the unit solar cell 2, it becomes possible to easily perform manufacturing at a low temperature. Accordingly, it is possible to obtain a highly productive solar cell module in which the connection can be completed in a short time. That is, by using a conductive adhesive to connect them, it becomes possible to avoid taking a long time, which is necessary when soldering is used.

Also, the insulating sheet 13 is formed so as to cause the first electrode connecting portion 11c to correspond to the first electrode 21 and the second electrode connecting portion 12c to correspond to the second electrode 22, and is deposited on the wiring sheet 10 in advance. With this configuration, the first conductor wire 11 and the second conductor wire 12 are insulated in advance. Accordingly, when disposing the wiring sheet 10 facing the unit solar cell 2, the need for an extra task of inserting an insulating sheet 13 that is necessary between the first and second conductor wires 11 and 12 and the unit solar cell 2 is eliminated, simplifying the manufacturing process, and the positioning of the solar cell wiring member 1 can be performed easily, improving productivity.

A method of manufacturing a solar cell module 3 will be described next. Here, a state before being completed is also referred to as solar cell module 3.

First of all, a light-transmitting protection plate 31 is prepared (light-transmitting protection plate preparation step), and a sealing resin sheet 32 is disposed on the light-transmitting protection plate 31 (surface sealing resin preparation step). The light-transmitting protection plate 31 is made of, for example, glass, and the sealing resin sheet 32 is made of, for example, an EVA (ethylene/vinyl acetate copolymer) resin sheet.

A unit solar cell 2 is disposed on the sealing resin sheet 32. That is, a unit solar cell 2 is prepared (cell preparation step). In the case of a structure in which a light-transmitting protection plate 31 and a unit solar cell 2 are integrated, understandably, the sealing resin sheet 32 can be omitted (in such a case, the light-transmitting protection plate preparation step and the cell preparation step can be combined into a cell preparation step).

On the unit solar cell 2, an insulating sheet 13 formed so as to cause the first electrode connecting portion 11c to correspond to the first electrode 21 and the second electrode connecting portion 12c to correspond to the second electrode 22 is positioned to and disposed (placed) on the non-light-receiving face (insulating sheet disposing step). In the case where a wiring sheet 10 is configured by depositing an insulating sheet 13 on the wiring sheet 10 in advance, the insulating sheet disposing step can be omitted, so the manufacturing process can be simplified, improving productivity.

A solar cell wiring member 1 is positioned to and disposed (placed) on the first electrode 21 and the second electrode 22, then, using a conductive adhesive, the first electrode connecting portion 11c of the first conductor wire 11 is connected to the first electrode 21, and the second electrode connecting portion 12c of the second conductor wire 12 is connected to the second electrode 22 (wiring member connecting step).

The wiring sheet 10 has first through portions 11h and second through portions 12h formed therein and is configured such that the corresponding first lead-out portions 11t and second lead-out portions 12t are exposed at the back surface (outside) side. In order to facilitate the connection of the exposed first lead-out portions 11t and second lead-out portions 12t to the outside, it is desirable to provide appropriate lead-out terminals to the lead-out portions in advance (lead-out terminal forming step).

A sealing resin sheet 33 is positioned on and disposed (placed) overlapping the non-light-receiving face and the solar cell wiring member 1 (sealing resin sheet disposing step). The sealing resin sheet 33 can be, for example, an EVA (ethylene/vinyl acetate copolymer) resin sheet as is the case with the sealing resin sheet 32.

In the sealing resin sheet 33, terminal holes 33h for leading out lead-out terminals (first lead-out portions 11t and second lead-out portions 12t) are formed at prescribed positions in advance. Before the sealing resin sheet 33 is firmly attached to the unit solar cell 2, it is desirable to fix the solar cell wiring member 1 with auxiliary fixing tape 14 in order to fix the position of the solar cell wiring member 1.

An exterior sheet 34 is positioned on and disposed (placed) overlapping the sealing resin sheet 33 (exterior sheet disposing step). The exterior sheet 34 can be, for example, a laminate of a PET film and a moisture proof material (e.g., an aluminum foil) attached thereto. In the exterior sheet 34, as in the sealing resin sheet 33, terminal holes 34h for leading out lead-out terminals (first lead-out portions 11t and second lead-out portions 12t) are formed at prescribed positions in advance.

With the wiring sheet 10, the sealing resin sheet 33 and the exterior sheet 34 being overlaid on the unit solar cell 2, the sealing resin sheet 33 is heated and pressed under vacuum to firmly attach the sealing resin sheet 33 to the unit solar cell 2, thereby sealing the unit solar cell 2 with resin (resin sealing step). By heating and pressing the sealing resin sheet 33 under vacuum, the occurrence of gaps between the unit solar cell 2, the wiring sheet 10, the sealing resin sheet 33 and the exterior sheet 34 can be prevented, and a highly reliable solar cell module 3 can be obtained. In the resin sealing step, the unit solar cell 2, the wiring sheet 10, the sealing resin sheet 33 and the exterior sheet 34 can be laminated and firmly attached.

In the resin sealing step, the sealing resin sheet 33 is semi-cured. By using a conductive adhesive with a lower melting point than the melting point of the sealing resin sheet 33, the conductive adhesive can be cured concurrently with the resin-sealing of the sealing resin sheet 33 in the resin sealing step. Accordingly, a highly productive manufacturing method of a solar cell module 3 with simplified process steps can be obtained. That is, it is desirable that the resin sealing step is performed with a heating temperature of approximately 100°C so that the sealing resin sheet 33 is semi-cured and the conductive adhesive is cured.

Also, the fixing holes 10h formed in the wiring sheet 10 are filled with the sealing resin sheet 33 in the resin sealing step, so the position of the wiring sheet 10 can be fixed, and the connection between the first electrode connecting portion 11c and the first electrode 21 as well as the connection between the second electrode connecting portion 12c and the second electrode 22 can be reinforced and stabilized.

The first lead-out portions 11t and the second lead-out portions 12t are configured such that they are connected to the outside of the exterior sheet 34 via the terminal holes 33h and 34h by the connection of lead-out terminals in the resin sealing step.

After the sealing resin sheet 33 has been semi-cured, and the conductive adhesive has been cured, the solar cell module 3 is heated in an oven to fully cure the sealing resin sheet 33 (sealing resin drying step). Then, an insulating treatment (for sealing end faces) is performed on the peripheral end of the solar cell module 3, a terminal box 35 is attached to the exterior sheet 34, output lead wires 36 are connected to the lead-out terminals corresponding to the first lead-out portions 11t and the second lead-out portions 12t via the terminal holes 33h and 34h.

Subsequently, a frame member 37 is attached to the solar cell module 3, completing the manufacture. The frame member 37 is ordinarily made of aluminum.

As described above, the manufacturing method of a solar cell module 3 according to the present embodiment involves: a cell preparation step of preparing a unit solar cell 2; a wiring member connecting step of positioning and disposing a solar cell wiring member 1 on a first electrode 21 and a second electrode 22 and connecting a first electrode connecting portion 11c of a first conductor wire 11 and a second electrode connecting portion 12c of a second conductor wire 12 to the first electrode 21 and the second electrode 22, respectively, with a conductive adhesive; a sealing resin sheet disposing step of disposing a sealing resin sheet 33 so as to overlap a non-light-receiving face and the solar cell wiring member 1; and a resin sealing step of resin-sealing the unit solar cell 2 by heating and pressing the sealing resin sheet 33.

With this configuration, it is possible to position the first conductor wire 11 to the first electrode 21 and position the second conductor wire 12 to the second electrode 22 with ease and high accuracy. Also, because a conductive adhesive is used to connect them, the connection time can be reduced, and the productivity of the solar cell module 3 can be improved.

### Embodiment 3

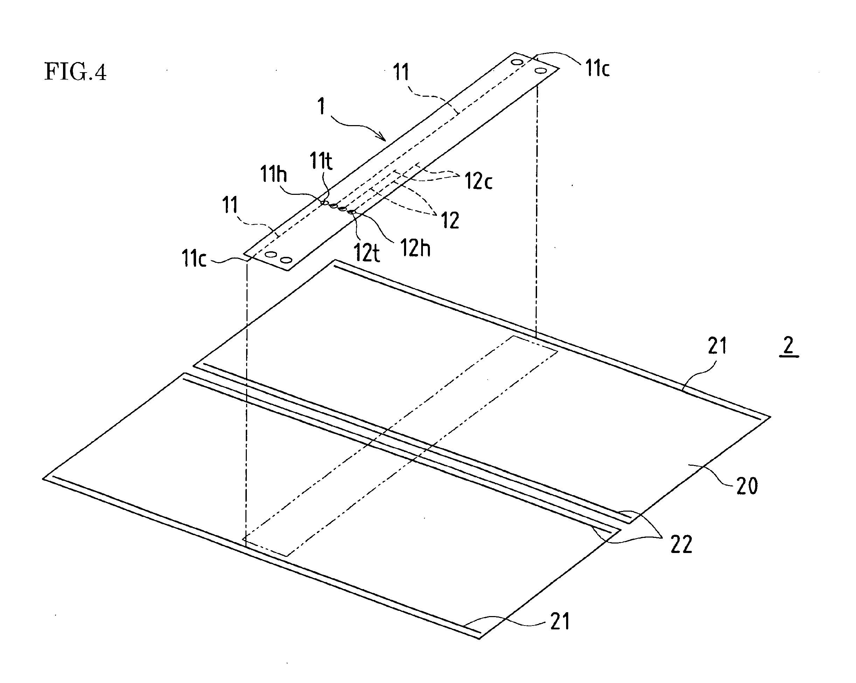

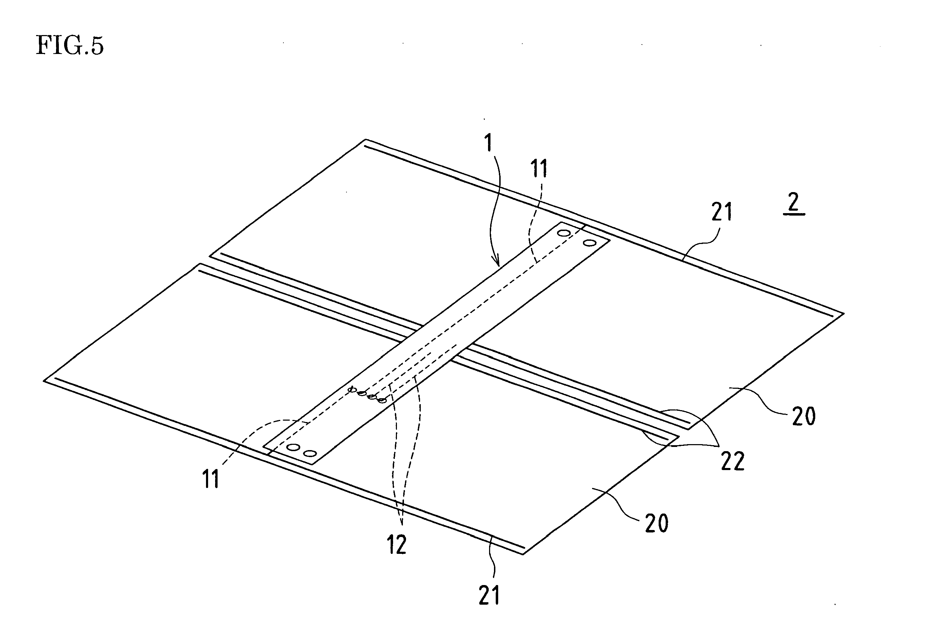

The relationship between the unit solar cell and the solar cell wiring member described in Embodiments 1 and 2 will be described in Embodiment 3 with reference to FIGS. 4 and 5.

FIG. 4 is an exploded perspective view showing the relationship between a unit solar cell and a solar cell wiring member that are applied to a solar cell module according to Embodiment 3 of the present invention. FIG. 5 is a perspective view showing a state in which the unit solar cell and the solar cell wiring member shown in FIG. 4 are laminated and connected. The basic configuration is the same as those of Embodiments 1 and 2 and, thus, mainly the differences will be described here.

A unit solar cell 2 of the present embodiment is a thin film solar cell. In addition, a first electrode 21 and a second electrode 22 for providing electricity are formed on the back surface side (non-light-receiving face side) of a photoelectric conversion portion 20. By the use of such a thin film solar cell, a highly productive and inexpensive solar cell module 3 can be obtained.

Because a configuration is adopted in which, for example, two unit solar cells 2 constitute a solar cell module 3, it is necessary to collect the respective electrodes of the two unit solar cells 2. That is, it is necessary to connect two first electrodes 21 and two second electrodes 22 that are disposed symmetrically in parallel on both ends of the unit solar cells 2.

In accordance with the solar cell wiring member 1 of the present embodiment, an appropriate wiring pattern can be set, so the present embodiment is applicable not only to the arrangement example of the present embodiment, but also to the case where more unit solar cells 2 are arranged.

As described above, the solar cell wiring member 1 is required to collect and connect the first electrodes 21 and the second electrodes 22 of two unit solar cells 2. Accordingly, two first conductor wires 11 that correspond to the first electrodes 21 and two second conductor wires 12 (two second electrode connecting portions 12c) that correspond to the second electrodes 22 are disposed in parallel. That is, the first conductor wires 11 and the second conductor wires 12 are disposed such that two first electrode connecting portions 11c correspond to two first electrodes 21 and two second electrode connecting portions 12c correspond to two second electrodes 22.

Also, two first through portions 11h and two second through portions 12h are disposed aligned with each other so as to correspond to a terminal box 35 through which the electricity from the unit solar cell 2 is provided. That is, two first lead-out portions 11t and two second lead-out portions 12t are disposed aligned with each other.

As already described in Embodiments 1 and 2, by positioning and laminating the solar cell wiring member 1 (first electrode connecting portions 11c, second electrode connecting portions 12c) on the unit solar cells 2 (first electrodes 21, second electrodes 22) and connecting the solar cell wiring member 1 and the unit solar cells 2 to each other with a conductive adhesive, it becomes possible to configure a wiring portion in which the solar cell wiring member 1 is connected to the unit solar cells 2 and through which electricity is provided from the unit solar cells 2 to the outside.

In addition, positioning can be achieved by performing positioning at both ends, so it is unnecessary to perform positioning at the center and as a result, the positioning step can be simplified. Furthermore, the accuracy of positioning at both ends will be the accuracy of positioning for the whole, so positioning accuracy can be improved.

As described above, according to the present embodiment, by applying the solar cell wiring member 1 of the present invention to a thin film solar cell in which elements are formed at a high density, it becomes possible to provide wiring with ease and high accuracy. Accordingly, a highly reliable solar cell module 3 can be obtained and, in addition, the solar cell module 3 can be manufactured with good productivity.

### Embodiment 4

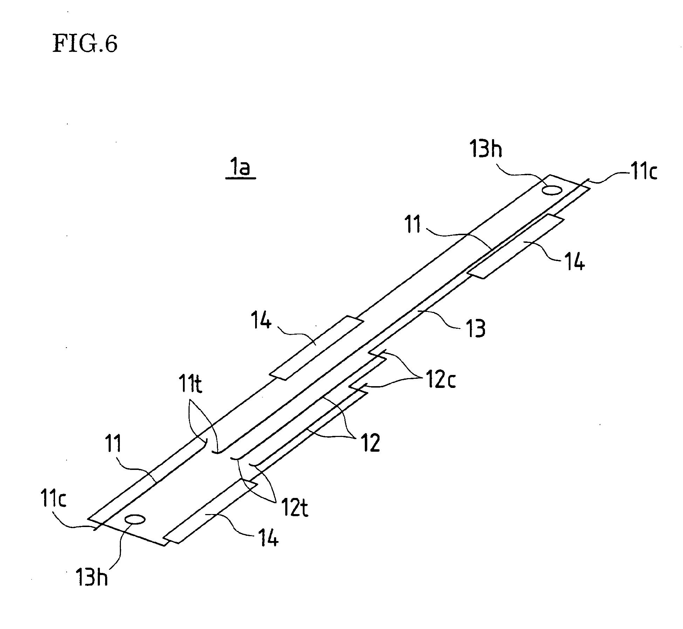

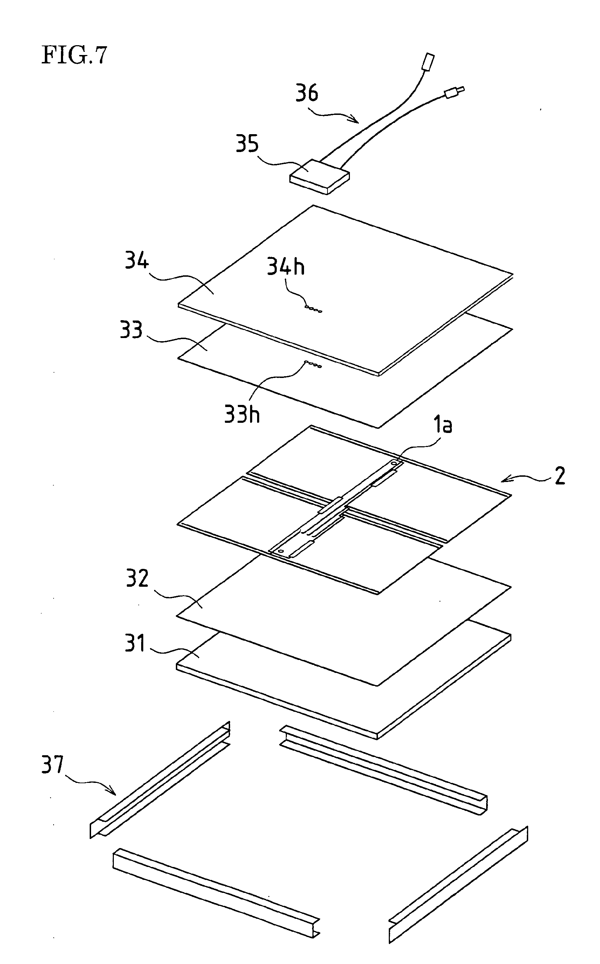

A solar cell wiring member and a solar cell module according to Embodiment 4 of the present invention will be described with reference to FIGS. 6 and 7.

FIG. 6 is a perspective view showing the outer appearance of a solar cell wiring member 1a according to Embodiment 4 of the present invention in its completed state. FIG. 7 is an exploded perspective view showing an overall configuration of a solar cell module used to illustrate a solar cell module and a method of manufacturing a solar cell module according to the present embodiment.

The solar cell wiring member 1a of the present embodiment is provided with a first conductor wire 11 connected to a first electrode 21 of a first polarity (e.g., p-electrode) formed on a non-light-receiving face of a unit solar cell 2 (see FIG. 7), a second conductor wire 12 connected to a second electrode 22 of a second polarity (e.g., n-electrode) formed on the non-light-receiving face of the unit solar cell 2, and an insulating sheet 13 in which the first conductor wire 11 and the second conductor wire 12 are fixed; and is configured such that the insulating sheet 13 is disposed facing the non-light-receiving face of the unit solar cell 2 so as to provide electricity to the outside by the first conductor wire 11 and the second conductor wire 12. Herein, a plurality of first conductor wires 11 and a plurality of second conductor wires 12 are arranged according to the number of unit solar cells 2.

As a method of fixing the first conductor wire 11 and the second conductor wire 12 onto the insulating sheet 13, it is possible to use any one of methods in which they are formed on the insulating sheet 13 using various conductive pastes, vapor deposition, etching, etc., and methods in which they are bonded onto the insulating sheet 13 with adhesives such as a polyester adhesive, an acrylic adhesive and an epoxy adhesive.

The connection between the first electrode connecting portion 11c of the first conductor wire 11 and the first electrode 21 as well as the connection between the second electrode connecting portion 12c of the second conductor wire 12 and the second electrode 22 can be achieved by disposing them so as to correspond to each other, and joining them with solder or bonding them with a conductive adhesive as in Embodiment 1. In order to fix the insulating sheet 13 to the unit solar cell 2, it is also possible to use auxiliary fixing tape 14 to tape the insulating sheet 13 to the unit solar cell 2 as in Embodiment 1.

A process of manufacturing a solar cell module according to the present embodiment is the same as the solar cell module manufacturing process described in Embodiment 2, except for the solar cell wiring member 1a, and the positioning and fixation of the insulating sheet 13 to the solar cell module 3 (the positioning and fixation thereof to the unit solar cell 2) can be performed by providing fixing holes (anchor holes) 13h in the insulating sheet 13, and filling the fixing holes 13h with a sealing resin supplied from the sealing resin sheet 33 in the resin sealing step of resin-sealing the unit solar cell 2 by heating and pressing the sealing resin sheet 33.

The first lead-out portions 11t of the first conductor wires 11 and the second lead-out portions 12t of the second conductor wires 12 are drawn to the outside through the terminal holes 33h of the sealing resin sheet 33 and the terminal holes 34h of the exterior sheet 34 and are connected to a terminal box 35.

According to the present embodiment, because the position of the first conductor wires and that of the second conductor wires are integrally fixed by the insulating sheet, it becomes possible to define the positioning between the first electrode and the first conductor wire as well as the positioning between the second electrode and the second conductor wire with ease and high accuracy so that they can be connected with good productivity. Accordingly, it is possible to manufacture a highly reliable solar cell module with superior productivity. That is, it is possible to provide wiring that can be easily incorporated into the solar cell wiring member and has high positional accuracy.

In addition, because the first conductor wires and the second conductor wires are fixed to the insulating sheet, the first conductor wires and the second conductor wires can be insulated in advance. Accordingly, the need for an extra task of inserting an insulating sheet between the first and second conductor wires and the unit solar cell can be eliminated, so the manufacturing process can be simplified, improving productivity.

The present invention may be embodied in various other forms without departing from the gist or essential characteristics thereof. Therefore, the embodiments disclosed in this application are to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority on Japanese Patent Application No. 2007-022023 filed in Japan on January 31, 2007, the entire contents of which are incorporated herein by reference. Furthermore, the entire contents of references cited in the present specification are herein specifically incorporated by reference.

### Industrial Applicability

The present invention can be effectively applied to a highly reliable solar cell module with high positional accuracy and superior productivity, a solar cell wiring member applied to such a solar cell module, and a method of manufacturing such a solar cell module.

## Claims

1. A solar cell module comprising: a unit solar cell in which a first electrode of a first polarity and a second electrode of a second polarity are formed in a non-light-receiving face; a solar cell wiring member that is disposed facing the non-light-receiving face and that provides electricity to the outside; and a sealing resin sheet that is laminated on the unit solar cell and the solar cell wiring member and that resin-seals the unit solar cell,
wherein the solar cell wiring member comprises a first conductor wire connected to the first electrode, a second conductor wire connected to the second electrode, and a wiring sheet in which the first conductor wire and the second conductor wire are formed,
the first conductor wire includes a first electrode connecting portion connected to the first electrode and a first lead-out portion that is connected to the outside via a first through portion formed through the wiring sheet,
the second conductor wire includes a second electrode connecting portion connected to the second electrode and a second lead-out portion that is connected to the outside via a second through portion formed through the wiring sheet, and
an insulating sheet that covers the first conductor wire and the second conductor wire to insulate the first conductor wire and the second conductor wire is disposed between the non-light-receiving face and the wiring sheet.

2. The solar cell module according to claim 1,
wherein the first electrode and the first electrode connecting portion as well as the second electrode and the second electrode connecting portion are connected with a conductive adhesive.

3. The solar cell module according to claim 1 or 2,
wherein the insulating sheet is formed so as to cause the first electrode connecting portion to correspond to the first electrode and the second electrode connecting portion to correspond to the second electrode, and is deposited on the wiring sheet.

4. The solar cell module according to any one of claims 1 to 3,
wherein the unit solar cell is a thin film solar cell.

5. A solar cell wiring member comprising: a first conductor wire that is connected to a first electrode of a first polarity formed in a non-light-receiving face of a unit solar cell; a second conductor wire that is connected to a second electrode of a second polarity formed in the non-light-receiving face of the unit solar cell; and a wiring sheet in which the first conductor wire and the second conductor wire are formed, the solar cell wiring member being disposed facing the non-light-receiving face of the unit solar cell and providing electricity to the outside,
wherein the first conductor wire includes a first electrode connecting portion that is connected to the first electrode and a first lead-out portion that is connected to the outside via a first through portion formed through the wiring sheet, and
the second conductor wire includes a second electrode connecting portion that is connected to the second electrode and a second lead-out portion connected to the outside via a second through portion formed through the wiring sheet.

6. The solar cell wiring member according to claim 5,
wherein an insulating sheet that is formed so as to cause the first electrode connecting portion to correspond to the first electrode and the second electrode connecting portion to correspond to the second electrode and that covers the first conductor wire and the second conductor wire to insulate the first conductor wire and the second conductor wire is deposited on the wiring sheet.

7. The solar cell wiring member according to claim 5 or 6,
wherein the first conductor wire and the second conductor wire are formed of a thin plate-like metal conductor.

8. The solar cell wiring member according to claim 5 or 6,
wherein the first conductor wire and the second conductor wire are formed of an aggregate of conductor particles.

9. A method of manufacturing a solar cell module comprising: a unit solar cell in which a first electrode of a first polarity and a second electrode of a second polarity are formed in a non-light-receiving face; a solar cell wiring member including a first conductor wire connected to the first electrode, a second conductor wire connected to the second electrode, and a wiring sheet in which the first conductor wire and the second conductor wire are formed, the solar cell wiring member that is disposed facing the non-light-receiving face and that provides electricity to the outside; and a sealing resin sheet that is laminated on the unit solar cell and the solar cell wiring member and that resin-seals the unit solar cell, the method comprising:
a cell preparation step of preparing the unit solar cell;
a wiring member connecting step of positioning and disposing the solar cell wiring member on the first electrode and the second electrode and connecting a first electrode connecting portion of the first conductor wire to the first electrode and a second electrode connecting portion of the second conductor wire to the second electrode with a conductive adhesive;
a sealing resin sheet disposing step of disposing the sealing resin sheet so as to overlap the non-light-receiving face and the solar cell wiring member; and
a resin sealing step of heating and pressing the sealing resin sheet to resin-seal the unit solar cell.

10. The method of manufacturing a solar cell module according to claim 9,
wherein the conductive adhesive has a melting point lower than the melting point of the sealing resin sheet.

11. The method of manufacturing a solar cell module according to claim 9 or 10,
wherein an insulating sheet that covers the first conductor wire and the second conductor wire to insulate the first conductor wire and the second conductor wire is deposited on the wiring sheet in advance.

12. A solar cell module comprising: a unit solar cell in which a first electrode of a first polarity and a second electrode of a second polarity are formed in a non-light-receiving face; a solar cell wiring member that is disposed facing the non-light-receiving face and that provides electricity to the outside; and a sealing resin sheet that is laminated on the unit solar cell and the solar cell wiring member and that resin-seals the unit solar cell,
wherein the solar cell wiring member comprises a first conductor wire connected to the first electrode, a second conductor wire connected to the second electrode, and an insulating sheet in which the first conductor wire and the second conductor wire are fixed; and is configured to provide electricity to the outside by the first conductor wire and the second conductor wire.

13. A solar cell wiring member comprising: a first conductor wire that is connected to a first electrode of a first polarity formed in a non-light-receiving face of a unit solar cell; a second conductor wire that is connected to a second electrode of a second polarity formed in the non-light-receiving face of the unit solar cell; and an insulating sheet in which the first conductor wire and the second conductor wire are fixed, the solar cell wiring member being disposed facing the non-light-receiving face of the unit solar cell and being configured to provide electricity to the outside by the first conductor wire and the second conductor wire.

14. A method of manufacturing a solar cell module comprising: a unit solar cell in which a first electrode of a first polarity and a second electrode of a second polarity are formed in a non-light-receiving face; a solar cell wiring member including a first conductor wire connected to the first electrode, a second conductor wire connected to the second electrode, and an insulating sheet in which the first conductor wire and the second conductor wire are fixed, the solar cell wiring member being disposed facing the non-light-receiving face and providing electricity to the outside; and a sealing resin sheet being laminated on the unit solar cell and the solar cell wiring member and resin-sealing the unit solar cell, the method comprising:
a cell preparation step of preparing the unit solar cell;
a wiring member connecting step of positioning and disposing the solar cell wiring member on the first electrode and the second electrode and connecting a first electrode connecting portion of the first conductor wire to the first electrode and a second electrode connecting portion of the second conductor wire to the second electrode;
a sealing resin sheet disposing step of disposing the sealing resin sheet so as to overlap the non-light-receiving face and the solar cell wiring member; and
a resin sealing step of heating and pressing the sealing resin sheet to resin-seal the unit solar cell.
